# EUROPEAN PATENT SPECIFICATION

(11) **EP 3 014 670 B1**
(45) Date of publication and mention of the grant of the patent: **05.04.2023**
(21) Application number: 14818119.1
(22) Date of filing: 27.06.2014
(51) Int. Cl.: H01L 51/44, B29C 63/02, B32B 38/18

(54) **FLEXIBLE ORGANIC PHOTOVOLTAIC DEVICE AND METHOD FOR MANUFACTURE THEREOF**
FLEXIBLE ORGANISCHE FOTOVOLTAISCHE ANORDNUNG UND VERFAHREN ZUR DEREN HERSTELLUNG
DISPOSITIF PHOTOVOLTAÏQUE ORGANIQUE FLEXIBLE ET SON PROCÉDÉ DE FABRICATION

(30) Priority: 28.06.2013 US 201361841243 P; 28.06.2013 US 201361841244 P; 28.06.2013 US 201361841251 P; 28.06.2013 US 201361841247 P; 28.06.2013 US 201361841248 P; 02.07.2013 US 201361842357 P; 02.07.2013 US 201361842355 P; 02.07.2013 US 201361842365 P; 02.07.2013 US 201361842375 P; 02.07.2013 US 201361842372 P; 03.07.2013 US 201361842796 P; 03.07.2013 US 201361842803 P
(43) Date of publication of application: 04.05.2016
(73) Proprietor: SolarWindow Technologies, Inc., Scottsdale, AZ 85260 (US)
(72) Inventor: CONKLIN, John, Anthony, Apalachin, NY 13732 (US); HAMMOND, Scott, Ryan, Wheat Ridge, CO 80215 (US); THOMPSON, J., Patrick, Canton, GA 30114 (US)
(74) Representative: Murgitroyd & Company
(86) International application number: PCT/US2014/044656
(87) International publication number: WO 2014/210508

(56) References cited:
- EP-A2- 2 311 101
- WO-A1-2009/086161
- WO-A1-2012/078517
- WO-A2-2010/042344
- WO-A2-2012/101207
- US-A1- 2006 130 894
- US-A1- 2006 130 894
- US-A1- 2009 095 706
- US-A1- 2011 192 454
- US-A1- 2011 192 454
- US-A1- 2012 298 974
- US-A1- 2012 298 974
- US-A1- 2013 098 436
- US-A1- 2013 127 005
- KALTENBRUNNER M ET AL: "Ultrathin and lightweight organic solar cells with high flexibility", NATURE COMMUNICATIONS, NATURE PUBLISHING GROUP, UNITED KINGDOM , 1 April 2012 (2012-04-01), pages 1-7, XP002682520, ISSN: 2041-1723, DOI: 10.1038/NCOMMS1772 Retrieved from the Internet: URL:http://www.nature.com/ncomms/journal/v 3/n4/full/ncomms1772.html [retrieved on 2012-04-03]
- KALTENBRUNNER, M. ET AL.: 'Ultrathin and lightweight organic solar cells with high flexibility''.' NATURE COMMUNICATIONS vol. 3, no. 770, 03 April 2012, pages 1 - 7, XP002682520 Retrieved from the Internet: <URL:http://www. nature .com/ncomms/joumal/v3/n4/full/ncomms1772.ht ml> [retrieved on 2014-09-23]
- HÖSEL, M.: 'Large-scale Roll-to-Roll Fabrication of Organic Solar Cells for Energy Production''.' PH.D. THESIS FOR TECHNICAL UNIVERSITY OF DENMARK, DEPARTMENT OF ENERGY CONVERSIONAND STORAGE XP055304868 Retrieved from the Internet: <URL:http://orbit.dtu.dk/wslfiles189079576/ phdthesis_markushoesel_final_online.pdf> [retrieved on 2014-10-01]

## Description

### FIELD OF THE INVENTION

The present invention is directed to a flexible organic photovoltaic (OPV) device and a method for the manufacture thereof.

### BACKGROUND OF THE INVENTION

OPV is an inherently flexible technology, which presents attractive potential applications that are incompatible with conventional inorganic photovoltaic materials. For example, Kaltenbrunner et. al {Nature Comm. DOI: 10.1038/ncomms 1772) has demonstrated that by using very thin substrates, supported with temporary substrates and coated via conventional spin coating techniques, very flexible OPV devices can be prepared with comparable performance to those produced on rigid substrates, and the devices can survive extreme elastic deformations.

### SUMMARY OF THE INVENTION

The present invention provides a flexible organic photovoltaic (OPV) device and a method of manufacturing the OPV device as defined in the claims.

The present application recognizes that the properties described by Kaltenbrunner et. al {Nature Comm. DOI: 10.1038/ncomms 1772) can be adapted and taken advantage of to provide novel methods for the preparation and use of highly flexible OPV devices.

Despite the work of Kaltenbrunner et. al {Nature Comm. DOI: 10.1038/ncomms 1772), the vast majority of OPV devices are not flexible, however, due to metallic conductor, typically a layer of indium tin oxide (ITO), and a highly crystalline transparent conductive oxide (TCO). All OPV devices require at least one transparent conductor (TC), which allows light to enter the device and reach the photoactive layer, while still transporting charge vertically and laterally to allow charge extraction from the device. ITO remains the TC of choice for most applications due to its favorable sheet resistance (Rₛ)/transparency tradeoff properties; it can have low Rₛ values of ~20 Ω/sqr for reasonable visible light transmission (VLT) values of -80%. ITO is extremely brittle, however, due to its highly crystalline nature, which leads to cracking at low tensile stresses, resulting in large increases in the Rₛ. As a result, ITO, along with many related crystalline TCOs are incompatible with flexible OPV devices.

The work of Kaltenbrunner et. al (Nature Comm. DOI: 10.1038/ncommsl772) utilized high conductivity poly(ethylenedioxythiophene):poly(styrene sulfonate) [PEDOT:PSS] as the flexible TC material for their OPV devices. High conductivity PEDOT:PSS is well known for its TC properties, its flexibility, and for its charge-collection layer properties. Low-conductivity PEDOT:PSS is often used as a hole-collection layer in standard and inverted architecture OPV devices, which is used to create hole-selectivity at an electrode; and high conductivity PEDOT:PSS can play both roles simultaneously. High conductivity PEDOT:PSS has several limitations as a TC material, however, importantly a relatively high Rₛ of around 80 Ω/sqr for 80% VLT. This relatively high Rₛ value, as compared to ITO, contributes to significant series resistance in large-area devices, where charges must travel significant lateral distances, whereas the work of Kaltenbrunner et. al (Nature Comm. DOI: 10.1038/ncomms1772) involved small devices of ~ 0.1 cm². Additionally, that work utilized the low work-function metal calcium as the effective electron-collection layer, topped by a silver metal electrode. While these ductile metals are inherently flexible, calcium is very reactive, spontaneously reacting with water and/or oxygen to produce insulating calcium oxide. As such, these devices have very poor lifetimes, and would be impractical for commercial products.

For semitransparent OPV devices, which are desirable for a number of applications, including SolarWindow^{™} (the subject of several US patent applications by Applicants), both electrodes must include TC materials. Due to the energy level alignment of PEDOT:PSS, which provides its hole-selectivity, it cannot serve as both TC materials, regardless of the Rₛ limitations discussed previously. Thus, other inherently flexible TC contacts are required for flexible semitransparent organic devices, and to maximize the performance of large-area devices, TCs with lower Rₛ values are desirable as well.

The present invention recognizes that conventional transparent conductor materials suffer from brittleness, high sheet resistance, charge selectivity, and/or other factors that restrict their use in flexible OPV devices, particularly semitransparent flexible OPV devices.

These problems and others are addressed by the present invention, a first exemplary embodiment of which comprises a method for the preparation of a flexible TC material supported by a very thin, highly flexible substrate, which can then be used to prepare flexible OPV devices. The highly flexible substrate, such as a very thin polyethylene terephthalate (PET) foil, is supported by a more rigid support substrate to facilitate device fabrication, with a transfer release layer incorporated to allow facile removal of the support substrate (and the release layer) after fabrication of the device. The thin substrate is then coated with an inherently flexible TC material. There are a number of such TC materials that may be used in this invention, including but not limited to: conductive polymers, such as high conductivity PEDOT:PSS; metal nanowire or carbon nanotube meshes; continuous graphene sheets or small overlapping graphene sheets; amorphous TCOs such as aluminum-doped zinc oxide (AZO), gallium-doped zinc oxide (GZO), or indium-doped zinc oxide (IZO); or any combinations thereof.

In one exemplary embodiment of the invention, the TC material comprises high conductivity PEDOT:PSS blended with silver nanowires, which increases the conductivity and reduces the Rₛ values compared to that of PEDOT:PSS alone, while maintaining or improving VLT, and simultaneously providing mechanical stability to the silver nanowires. Such a system has the benefit of being solution processable, enabling low-cost, high-throughput roll-to-roll, sheet-to-sheet, graveur, etc. coating methods for manufacturing.

In another exemplary embodiment, the TC material comprises one of the amorphous TCOs such as AZO, GZO, IZO, etc. These materials have the benefit of having very low Rₛ values and reasonable VLTs, both comparable to those of ITO, while still being flexible due to their amorphous nature. These materials generally require sputter-deposition, and/or very high processing temperatures, however, which can complicate their use, increase costs, and decrease throughput.

In another exemplary embodiment, the TC material comprises graphene dispersions blended with silver nanowires. While the consensus in the literature appears to be that graphene by itself, either in continuous sheets or small overlapping sheets, does not have sufficient conductivity to be an attractive TC material, in combination with silver nanowires, it may prove to have attractive TC properties due to the favorable combination of one-dimensional and two-dimensional conductors. Additionally, such a combination is both inherently flexible and potentially compatible with solution processing, particularly when utilizing dispersions of small graphene flakes.

The afore-mentioned flexible TC materials are provided for descriptive purposes only, and are not meant to be exhaustive in nature.

A further exemplary embodiment of the invention comprises a method for the preparation of a flexible OPV device, comprising one or more cells connected in series and/or parallel, on the flexible TC material described in the previous exemplary embodiments. After the TC material is deposited on the thin flexible substrate, which is laminated on the supporting substrate and release layer, the rest of the flexible multilayer OPV device may be deposited. This may include a charge-collection layer (CCL), followed by the photoactive layer, which generally comprises a bulk heterojunction (BHJ) between an electron-donor and an electron acceptor material. This may be followed by an additional CCL, of opposite polarity as the first one. The materials and methods for deposition of these layers is known to those skilled in the art of OPV, and generally can be compatible with solution-processing to ensure low-costs and high-throughput. Next, a ductile top metal electrode is deposited, such as silver. Metal electrodes can be deposited via a number of methods, from screen-printing to evaporation, some of which are compatible with high-throughput, roll-to-roll, sheet-to-sheet, graveur, etc. coating methods for manufacturing methods. In some embodiments, when the device being fabricated is a module, there may be additional processing steps, such as laser and/or mechanical scribing, to allow fabrication of series and/or parallel interconnected devices. In some embodiments, these steps may be located in between device layer deposition steps, and in some embodiments, these may be performed at the end. After the flexible OPV device is completed, a pressure-sensitive adhesive is applied to the surface of the device using coating techniques as known to those skilled in the art. The thin, flexible substrate along with the completed OPV device, including TC, may then be removed from the supporting substrate using the release layer to provide a very thin, highly flexible OPV device that may be adhered to objects of arbitrary shape.

An additional exemplary embodiment of the invention comprises a method for the preparation of a semitransparent flexible OPV device, comprising one or more cells connected in series and/or parallel, on the flexible TC material described in the previous exemplary embodiments. As in the previous embodiments, the initial flexible TC layer is then coated with the remainder of the layers of a semitransparent OPV device, as is known to those skilled in the art of OPV. Such layers may include one or two CCL layers, sandwiching the BHJ layer. In either case, the BHJ is chosen such that the light absorption of the materials ensures a reasonable degree of VLT and attractive aesthetics. In all cases, the final layer of the semitransparent OPV device comprises another TC layer, rather than a metal layer. If the TC layer does not also function as a CCL, then the same TC can be used on both sides of the device. If the TC layer does function as a CCL, such as PEDOT:PSS (alone or in blends), then it cannot be used on both sides of the device, and an alternative flexible TC material must be chosen, such as one of those from the previous exemplary embodiments. The TC layers must be chosen appropriately, along with the CCL layers, to ensure proper energy level alignment to ensure favorable electron and hole transport in the devices, as known to those skilled in the art. After the TC layer is deposited, a metal grid may be deposited as well, to aid in current collection/transport. As previously described, in some example embodiments, additional processing steps may be performed to enable fabrication of series- and/or parallel-interconnected modules. After the semitransparent OPV device is completed, a pressure-sensitive adhesive is applied to the surface of the device using coating techniques as known to those skilled in the art. The thin, flexible substrate along with the completed semitransparent OPV device may then be removed from the support substrate and release layer, and adhered to semitransparent objects of arbitrary shapes, such as curved windows or plastic canopy's and fixtures.

Other features and advantages of the present invention will become apparent to those skilled in the art upon review of the following detailed description and drawings.

### BRIEF DESCRIPTION OF THE DRAWINGS

These and other aspects and features of embodiments of the present invention will be better understood after a reading of the following detailed description, together with the attached drawings, wherein:

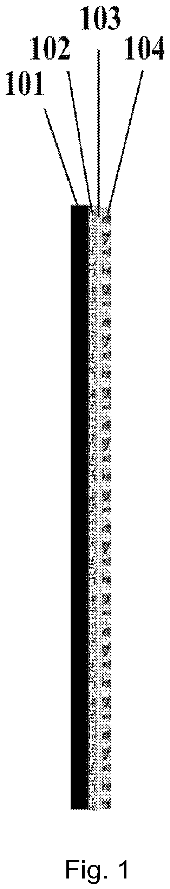

Figure 1 is a cross-sectional view of a flexible transparent conductor, coated on a thin flexible substrate with a transfer release layer and support layer, which can be used to prepare flexible OPV devices, according to an exemplary embodiment not within the scope of the invention as claimed.

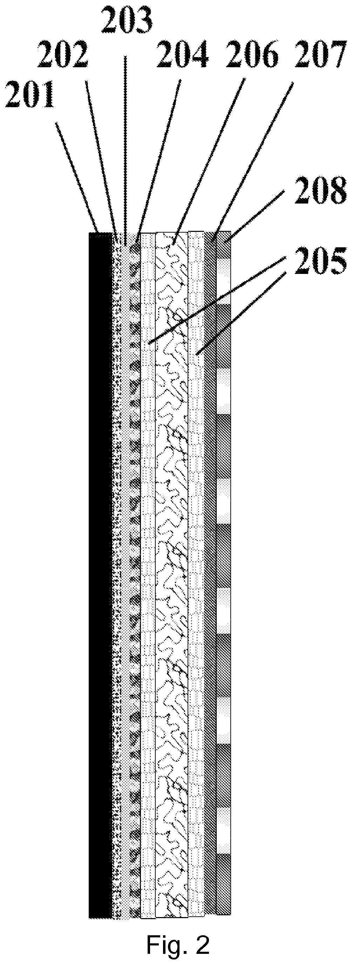

Figure 2 is a cross-sectional view of a flexible OPV device coated onto the flexible transparent conductor film of Figure 1, including charge-collection layers, the bulk heterojunction layer, a ductile top metal electrode, and a pressure-sensitive adhesive layer, according to an exemplary embodiment not within the scope of the invention as claimed.

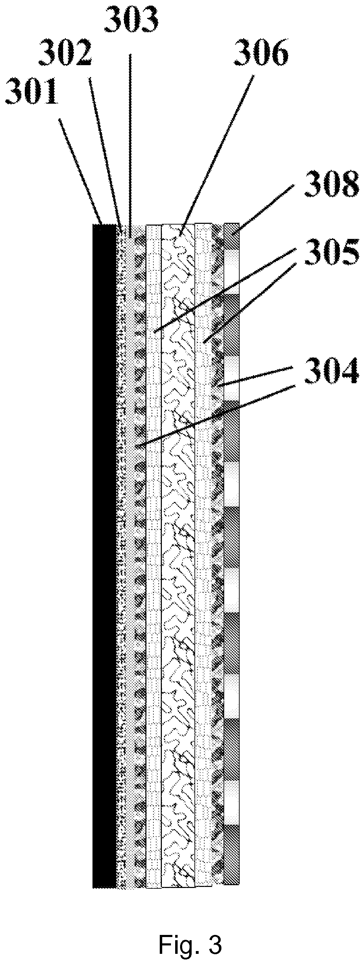

Figure 3 is a cross-sectional view of a flexible semitransparent OPV device coated onto the flexible transparent conductor film of Figure 1, including charge-collection layers, the bulk heterojunction layer, a second transparent conductor, and a pressure-sensitive adhesive layer, according to the invention.

### DETAILED DESCRIPTION OF THE EXEMPLARY EMBODIMENTS OF THE INVENTION

Referring now to the drawings, Figures 1-3 illustrate exemplary embodiments of the method for preparing and using flexible transparent conductors in the production of flexible OPV devices (Figures 1-3), including semitransparent OPV devices (Figure 3).

Referring to Figure 1, which provides a cross-sectional view of a flexible TC film for the preparation of flexible OPV devices, the film is prepared upon a temporary support layer 101, in order to provide sufficient rigidity to allow conventional manufacturing techniques, including high-speed roll-to-roll, sheet-to-sheet, graveur, etc. coating methods. The support layer can include glass or thick metal rigid substrates, flexible polymer or metal foils, or any convenient substrate material, depending on the chosen manufacturing methods. On top of the support layer is a transfer release layer 102 that allows easy removal of the support layer and transfer layer from the thin flexible substrate 103, which are all laminated together as known to those skilled in the art. The thin flexible substrate is any appropriate substrate material that is highly flexible and transparent, such as very thin polymer foils, including but not limited to polyethyleneterephthalate (PET). On top of this is coated a TC material 104, which can include a number of materials, including but not limited to: conductive polymers, such as high conductivity PEDOT:PSS; metal nanowire or carbon nanotube meshes; continuous graphene sheets or small overlapping graphene sheets; amorphous TCOs such as aluminum-doped zinc oxide (AZO), gallium-doped zinc oxide (GZO), or indium-doped zinc oxide (IZO); or any combinations thereof. The coating methodology depends on the specific materials chosen, and is known to those skilled in the art.

Referring to Figure 2, which provides a cross-sectional view of a flexible OPV device prepared from the flexible TC film of Figure 1, the film is prepared upon a temporary support layer 201. On top of the support layer is a transfer release layer 202 that allows easy removal of the support layer and transfer layer from the thin flexible substrate 203, which are all laminated together. On top of the flexible substrate is the TC material 204. Coated on top of the TC is the rest of the flexible OPV device, including two CCLs 205, sandwiching the BHJ 206, the ductile metal top contact 207, and the pressure-sensitive adhesive 208, that allows the flexible OPV device to be adhered to objects of arbitrary shape. In this exemplary embodiment, the CCLs are necessarily different materials with opposing polarities, and the CCLs, TC, BHJ and metal electrode materials all must be chosen to have appropriate energy levels to ensure favorable electron transport in the device, as known to those skilled in the art.

Referring to Figure 3, which provides a cross-sectional view of a semitransparent flexible OPV device prepared from the flexible TC film of Figure 1, the film is prepared upon a temporary support layer 301. On top of the support layer is a transfer release layer 302 that allows easy removal of the support layer and transfer layer from the thin flexible substrate 303, which are all laminated together. On top of the flexible substrate is the TC material 304. Coated on top of the TC is the rest of the flexible OPV device, including two CCLs 305, sandwiching the BHJ 306, a second TC material 304, and the pressure-sensitive adhesive 308, that allows the semitransparent flexible OPV device to be adhered to semitransparent objects of arbitrary shape. Again, in this exemplary embodiment, the CCLs are necessarily different materials with opposing polarities, while the TCs may or may not be identical materials, depending on the nature of the TC materials chosen. In the exemplary embodiment, the CCLs, TCs, and BHJ materials all must be chosen to have appropriate energy levels to ensure favorable electron transport in the device, as known to those skilled in the art.

## Claims

1. A flexible organic photovoltaic (OPV) device prepared from a transparent conductor film, wherein the OPV device comprises:
the flexible transparent conductor film, which includes:
a support substrate (301);
a flexible transparent substrate (303); and
a transfer release layer (302) laminated between the support substrate (301) and
the flexible transparent substrate (303); and
a first transparent conductor layer (304) on top of the flexible transparent substrate (303);
a first charge-collection layer (305) coated on top of the first transparent conductor layer (304);
a bulk heterojunction (BHJ) photoactive layer (306) coated on top of the first charge-collection layer (305);
a second charge-collection layer (305) coated on top of the bulk heterojunction photoactive layer (306), wherein the second charge-collection layer (305) is of opposite polarity as the first charge- collection layer (305), and wherein the second charge-collection layer (305) is formed of a different material than the first charge-collection layer (305);
a second transparent conductor layer (304) coated on top of the second charge-collection layer (305); and
a transparent pressure-sensitive adhesive (308) on the second transparent conductor layer (304) on an opposite side of the flexible transparent conductor film from the support substrate (301) and capable of adhering the transparent conductor layer (304) to a curved surface of a semi-transparent object after the support substrate (301) is removed from the opposite side of the flexible transparent conductor film.

2. The flexible OPV device of claim 1, wherein the support substrate is a flexible material.

3. The flexible OPV device of claim 1 or 2, wherein the first transparent conductor layer (304) material comprises a blend of PEDOT:PSS and silver nanowires.

4. The flexible OPV device of claim 1 or 2, wherein the first transparent conductor layer (304) comprises a blend of graphene flakes and silver nanowires.

5. The flexible OPV device of claim 1 or 2, wherein the first transparent conductor layer (304) comprises an amorphous transparent conductive oxide.

6. The flexible OPV device of claim 5, wherein the first transparent conductor layer and second transparent conductor layer are made of identical materials comprised of an amorphous transparent conductive oxide.

7. The flexible OPV device of claim 1 or 2, wherein the first transparent conductor layer is made of a different material than the second transparent conductor layer, and wherein one of the transparent conductor layer and the second transparent conductor layer comprises a blend of PEDOT:PSS and silver nanowires.

8. The flexible OPV device of claim 2, wherein the flexible material includes one of a polymer and a metal foil.

9. The OPV device of claim 5 or 6, wherein the amorphous transparent conductive oxide includes at least one of aluminum-doped zinc oxide, gallium- doped zinc oxide, and indium-doped zinc oxide.

10. A method for the manufacture of the flexible OPV device of any preceding claim, comprising:
coating the support substrate (301) with the transfer release layer (302),
laminating the support substrate (301) and the transfer release layer (303) with the flexible transparent substrate (302); and
coating the flexible transparent substrate with the first transparent conductor layer; and
coating the first transparent conductor layer with:
a first charge-collection layer (305) coated on top of the first transparent conductor layer (304);
a bulk heterojunction (BHJ) photoactive layer (306) coated on top of the first charge-collection layer (305);
a second charge-collection layer (305) on top of the bulk heterojunction photoactive layer (306), wherein the second charge-collection layer (305) is of opposite polarity as the first charge- collection layer (305), and wherein the second charge-collection layer (305) is formed of a different material than the first charge-collection layer (305);
a second transparent conductor layer (304) coated on top of the second charge-collection layer (305); and
a transparent pressure-sensitive adhesive (308) on the second transparent conductor layer (304) using at least one of a roll-to-roll, a sheet-to-sheet, and a graveur coating method of manufacturing, and utilizing solution-processing.

11. The method of claim 10, wherein coating the flexible transparent substrate with the first transparent conductor layer comprises coating the flexible transparent substrate (302) with amorphous transparent conducting oxide contact material.

12. The method of claims 10 or 11, wherein the flexible transparent substrate is polyethylene terephthalate (PET).

## Patentansprüche

1. Eine flexible organische Photovoltaik(OPV)-Vorrichtung, die aus einer transparenten Leiterfolie hergestellt ist, wobei die OPV-Vorrichtung Folgendes beinhaltet:
die flexible transparente Leiterfolie, die Folgendes umfasst:
ein Stützsubstrat (301);
ein flexibles transparentes Substrat (303); und
eine zwischen dem Stützsubstrat (301) und dem flexiblen transparenten Substrat (303) laminierte Transfertrennschicht (302);
und
eine erste transparente Leiterschicht (304) oben auf dem flexiblen transparenten Substrat (303);
eine erste Ladungssammelschicht (305), mit der die erste transparente Leiterschicht (304) oben beschichtet ist;
eine photoaktive Bulk-Heteroübergangs(BHJ)-Schicht (306), mit der die erste Ladungssammelschicht (305) oben beschichtet ist;
eine zweite Ladungssammelschicht (305), mit der die photoaktive Bulk-Heteroübergangsschicht (306) oben beschichtet ist, wobei die zweite Ladungssammelschicht (305) die entgegengesetzte Polarität hat wie die erste Ladungssammelschicht (305) und wobei die zweite Ladungssammelschicht (305) aus einem anderen Material gebildet ist als die erste Ladungssammelschicht (305);
eine zweite transparente Leiterschicht (304), mit der die zweite Ladungssammelschicht (305) oben beschichtet ist; und
einen transparenten Haftkleber (308) auf der zweiten transparenten Leiterschicht (304) auf einer dem Stützsubstrat (301) entgegengesetzten Seite der flexiblen transparenten Leiterfolie, und der in der Lage ist, die transparente Leiterschicht (304) auf eine gekrümmte Oberfläche eines halbtransparenten Gegenstandes zu kleben, nachdem das Stützsubstrat (301) von der entgegengesetzten Seite der flexiblen transparenten Leiterfolie entfernt worden ist.

2. Flexible OPV-Vorrichtung gemäß Anspruch 1, wobei das Stützsubstrat ein flexibles Material ist.

3. Flexible OPV-Vorrichtung gemäß Anspruch 1 oder 2, wobei das Material der ersten transparenten Leiterschicht (304) eine Mischung aus PEDOT:PSS und Silbernanodrähten beinhaltet.

4. Flexible OPV-Vorrichtung gemäß Anspruch 1 oder 2, wobei die erste transparente Leiterschicht (304) eine Mischung von Graphenflocken und Silbernanodrähten beinhaltet.

5. Flexible OPV-Vorrichtung gemäß Anspruch 1 oder 2, wobei die erste transparente Leiterschicht (304) ein amorphes transparentes leitfähiges Oxid beinhaltet.

6. Flexible OPV-Vorrichtung gemäß Anspruch 5, wobei die erste transparente Leiterschicht und zweite transparente Leiterschicht aus identischen Materialien hergestellt sind, die aus einem amorphen transparenten leitfähigen Oxid bestehen.

7. Flexible OPV-Vorrichtung gemäß Anspruch 1 oder 2, wobei die erste transparente Leiterschicht aus einem anderen Material hergestellt ist als die zweite transparente Leiterschicht und wobei eine von der transparenten Leiterschicht und der zweiten transparenten Leiterschicht eine Mischung aus PEDOT:PSS und Silbernanodrähten beinhaltet.

8. Flexible OPV-Vorrichtung gemäß Anspruch 2, wobei das flexible Material eines von einem Polymer und einer Metallfolie umfasst.

9. OPV-Vorrichtung gemäß Anspruch 5 oder 6, wobei das amorphe transparente leitfähige Oxid mindestens eines von aluminiumdotiertem Zinkoxid, galliumdotiertem Zinkoxid und indiumdotiertem Zinkoxid umfasst.

10. Ein Verfahren zur Fertigung der flexiblen OPV-Vorrichtung gemäß einem der vorhergehenden Ansprüche, das Folgendes beinhaltet:
Beschichten des Stützsubstrats (301) mit der Transfertrennschicht (302),
Laminieren des Stützsubstrats (301) und der Transfertrennschicht (303) mit dem flexiblen transparenten Substrat (302); und
Beschichten des flexiblen transparenten Substrats mit der ersten transparenten Leiterschicht; und
Beschichten der ersten transparenten Leiterschicht mit:
einer ersten Ladungssammelschicht (305), mit der die erste transparente Leiterschicht (304) oben beschichtet wird;
einer photoaktiven Bulk-Heteroübergangs(BHJ)-Schicht (306), mit der die erste Ladungssammelschicht (305) oben beschichtet wird;
einer zweiten Ladungssammelschicht (305) oben auf der photoaktiven Bulk-Heteroübergangsschicht (306),
wobei die zweite Ladungssammelschicht (305) die entgegengesetzte Polarität hat wie die erste Ladungssammelschicht (305) und wobei die zweite Ladungssammelschicht (305) aus einem anderen Material gebildet wird als die erste Ladungssammelschicht (305);
einer zweiten transparenten Leiterschicht (304), mit der die zweite Ladungssammelschicht (305) oben beschichtet wird; und
einem transparenten Haftkleber (308) auf der zweiten transparenten Leiterschicht (304) unter Verwendung von mindestens einem von einem Rolle-zu-Rolle-, einem Sheet-to-Sheet- und einem Gravur-Beschichtungsfertigungsverfahren und unter Einsatz von Lösungsverarbeitung.

11. Verfahren gemäß Anspruch 10, wobei das Beschichten des flexiblen transparenten Substrats mit der ersten transparenten Leiterschicht das Beschichten des flexiblen transparenten Substrats (302) mit Kontaktmaterial aus amorphem transparentem leitfähigem Oxid beinhaltet.

12. Verfahren gemäß Ansprüchen 10 oder 11, wobei das flexible transparente Substrat Polyethylenterephthalat (PET) ist.

## Revendications

1. Un dispositif photovoltaïque organique (OPV) flexible préparé à partir d'un film conducteur transparent, le dispositif OPV comprenant :
le film conducteur transparent flexible, lequel inclut :
un substrat de support (301) ;
un substrat transparent flexible (303) ; et
une couche de libération et de transfert (302) stratifiée entre le substrat de
support (301) et le substrat transparent flexible (303) ;
et
une première couche conductrice transparente (304) sur le dessus du substrat transparent flexible (303) ;
une première couche de collecte de charge (305) appliquée comme revêtement sur le dessus de la première couche conductrice transparente (304) ;
une couche photoactive (306) d'hétérojonction en vrac (BHJ) appliquée comme revêtement sur le dessus de la première couche de collecte de charge (305) ;
une deuxième couche de collecte de charge (305) appliquée comme revêtement sur le dessus de la couche photoactive (306) d'hétérojonction en vrac, dans lequel la deuxième couche de collecte de charge (305) est d'une polarité opposée à celle de la première couche de collecte de charge (305), et dans lequel la deuxième couche de collecte de charge (305) est formée d'un matériau différent de celui de la première couche de collecte de charge (305) ;
une deuxième couche conductrice transparente (304) appliquée comme revêtement sur le dessus de la deuxième couche de collecte de charge (305) ; et
un adhésif transparent sensible à la pression (308) sur la deuxième couche conductrice transparente (304) sur un côté opposé du film conducteur transparent flexible du substrat de support (301) et capable de faire adhérer la couche conductrice transparente (304) sur une surface incurvée d'un objet semi-transparent après que le substrat de support (301) est retiré du côté opposé du film conducteur transparent flexible.

2. Le dispositif OPV flexible de la revendication 1, dans lequel le substrat de support est un matériau flexible.

3. Le dispositif OPV flexible de la revendication 1 ou de la revendication 2, dans lequel le matériau de la première couche conductrice transparente (304) comprend un mélange homogène de PEDOT:PSS et de nanofils d'argent.

4. Le dispositif OPV flexible de la revendication 1 ou de la revendication 2, dans lequel la première couche conductrice transparente (304) comprend un mélange homogène de flocons de graphène et de nanofils d'argent.

5. Le dispositif OPV flexible de la revendication 1 ou de la revendication 2, dans lequel la première couche conductrice transparente (304) comprend un oxyde conducteur transparent amorphe.

6. Le dispositif OPV flexible de la revendication 5, dans lequel la première couche conductrice transparente et la deuxième couche conductrice transparente sont constituées de matériaux identiques composés d'un oxyde conducteur transparent amorphe.

7. Le dispositif OPV flexible de la revendication 1 ou de la revendication 2, dans lequel la première couche conductrice transparente est constituée d'un matériau différent de celui de la deuxième couche conductrice transparente, et dans lequel une couche parmi la couche conductrice transparente et la deuxième couche conductrice transparente comprend un mélange homogène de PEDOT:PSS et de nanofils d'argent.

8. Le dispositif OPV flexible de la revendication 2, dans lequel le matériau flexible inclut un élément parmi un polymère et une feuille mince métallique.

9. Le dispositif OPV de la revendication 5 ou de la revendication 6, dans lequel l'oxyde conducteur transparent amorphe inclut au moins un élément parmi un oxyde de zinc dopé à l'aluminium, un oxyde de zinc dopé au gallium, et un oxyde de zinc dopé à l'indium.

10. Un procédé pour la fabrication du dispositif OPV flexible de n'importe quelle revendication précédente, comprenant :
le revêtement du substrat de support (301) avec la couche de libération et de transfert (302),
la stratification du substrat de support (301) et de la couche de libération et de transfert (303) avec le substrat transparent flexible (302) ; et
le revêtement du substrat transparent flexible avec la première couche conductrice transparente ; et
le revêtement de la première couche conductrice transparente avec :
une première couche de collecte de charge (305) appliquée comme revêtement sur le dessus de la première couche conductrice transparente (304) ;
une couche photoactive (306) d'hétérojonction en vrac (BHJ) appliquée comme revêtement sur le dessus de la première couche de collecte de charge (305) ;
une deuxième couche de collecte de charge (305) sur le dessus de la couche photoactive (306) d'hétérojonction en vrac,
dans lequel la deuxième couche de collecte de charge (305) est d'une polarité opposée à celle de la première couche de collecte de charge (305), et dans lequel la deuxième couche de collecte de charge (305) est formée d'un matériau différent de celui de la première couche de collecte de charge (305) ;
une deuxième couche conductrice transparente (304) appliquée comme revêtement sur le dessus de la deuxième couche de collecte de charge (305) ; et
un adhésif transparent sensible à la pression (308) sur la deuxième couche conductrice transparente (304)
à l'aide d'au moins un procédé de fabrication parmi un procédé de fabrication par revêtement rouleau à rouleau, feuille à feuille, et par gravure, et au moyen d'un traitement en solution.

11. Le procédé de la revendication 10, dans lequel le revêtement du substrat transparent flexible avec la première couche conductrice transparente comprend le revêtement du substrat transparent flexible (302) avec un matériau de contact oxyde conducteur transparent amorphe.

12. Le procédé des revendications 10 ou 11, dans lequel le substrat transparent flexible est du polyéthylène téréphtalate (PET).
